**Europäisches Patentamt**

**European Patent Office**

**Office européen des brevets**

(11) Veröffentlichungsnummer: **0 190 997 B1**

# EUROPÄISCHE PATENTSCHRIFT

(45) Veröffentlichungstag der Patentschrift: **09.10.91**

(51) Int. Cl.5: **B41M 1/30, B41M 5/24, B41M 5/26**

(21) Anmeldenummer: **86810054.6**

(22) Anmeldetag: **30.01.86**

Die Akte enthält technische Angaben, die nach dem Eingang der Anmeldung eingereicht wurden und die nicht in dieser Patentschrift enthalten sind.

(54) Laserbeschriftung pigmentierter Systeme.

(30) Priorität: **05.02.85 CH 515/85**
**20.02.85 CH 789/85**

(43) Veröffentlichungstag der Anmeldung:
**13.08.86 Patentblatt 86/33**

(45) Bekanntmachung des Hinweises auf die Patenterteilung:
**09.10.91 Patentblatt 91/41**

(84) Benannte Vertragsstaaten:
**AT BE CH DE FR GB IT LI NL SE**

(56) Entgegenhaltungen:
**EP-A- 0 027 532       EP-A- 0 036 680**
**EP-A- 0 111 357       FR-A- 2 495 982**
**GB-A- 1 316 398       GB-A- 1 353 063**
**US-A- 3 832 948       US-A- 4 032 691**

(73) Patentinhaber: **CIBA-GEIGY AG**
**Klybeckstrasse 141**
**CH-4002 Basel(CH)**

(72) Erfinder: **Gugger, Heinrich, Dr.**
**Im Marcoup 8**
**CH-3280 Muntelier(CH)**
Erfinder: **Bühler, Niklaus, Dr.**
**Route du Pâquier 8**
**CH-1723 Marly(CH)**
Erfinder: **Breitenfellner, Franz, Dr.**
**Konrad-Adenauer-Strasse 56**
**W-6140 Bensheim 1(DE)**
Erfinder: **Hofmann, Manfred, Dr.**
**Route de Bel-Air 54**
**CH-1723 Marly(CH)**

## Beschreibung

Die vorliegende Erfindung betrifft ein Verfahren zur Beschriftung von hochmolekularem organischem Material, sowie das beschriftete Material.

Es ist beispielsweise gemäss dem Sonderdruck aus Pack Report Nr. 1, Januar 1981, Seite 4, bekannt, Kunststoffe, wie PVC, durch Laserbestrahlung so zu beschriften, dass die aufgebrachte Energie eine mechanische Veränderung oder eine Verfärbung des Kunststoffes an der Markierstelle erzeugt. Hierfür werden $CO_2$-Laser verwendet, die im IR-Bereich bei 10,6 $\mu$m strahlen.

Es ist ferner bekannt, Kunststoffteile enthaltend einen verfärbbaren Füllstoff durch Energiebestrahlung zu beschriften. So werden gemäss der US-Patentschrift Nr. 4,307,047 Kunststofftasten auf der Basis von ABS und enthaltend als verfärbbaren Füllstoff einen sogenannten Thermofarbstoff durch Laserbestrahlung beschriftet, wobei der Thermofarbstoff bei der einer der Form des aufzubringenden Zeichens angepassten Wärmeeinstrahlung einen dauerhaften Farbumschlag ergibt. Zur Bestrahlung werden Nd:YAG-Laser mit einer im IR-Bereich strahlenden Wellenlänge von 1,06 $\mu$m (= 1064 nm) eingesetzt.

Die EP-A-111357 offenbart ein Verfahren zur Beschriftung von Polyolefinen, welche eine genügende Menge einer Laserstrahlung absorbierenden Substanz enthalten, um die Zerstörung des Polyolefins durch die Energie des Laserstrahls zu gewährleisten. Verwendet werden $CO_2$-Laser einer Wellenlänge von 10,6 $\mu$m.

Die EP-A-36680 beschreibt ein Verfahren zur Laserbeschriftung von Kunststoffen, deren Oberfläche einen Farbstoff und eine siliciumhaltige anorganische Verbindung oder nur einen siliciumhaltigen Farbstoff enthält.

Schliesslich wird gemäss DE-AS Nr. 2,542,680 ein Verfahren zum Aufzeichnen von Informationen vorgeschlagen, nach welchem als lichtabsorbierenden Stoff ein in einem Polymer gelöstes Acetylacetonat und als Lichtquelle ein Laserstrahl einer Wellenlänge des sichtbaren Bereiches verwendet werden.

Gegenstand der vorliegenden Erfindung ist ein Verfahren zur Beschriftung von hochmolekularem organischem Material enthaltend mindestens einen strahlungsempfindlichen, eine Verfärbung verursachenden Zusatzstoff, dadurch gekennzeichnet, dass man als Energiestrahlung Laserlicht, dessen Wellenlänge im nahen UV- und/oder sichtbaren und/oder nahen IR-Bereich liegt, und als Zusatzstoff mindestens ein anorganisches und/oder organisches Pigment und/oder einen polymerlöslichen Farbstoff verwendet.

Das hochmolekulare organische Material kann natürlicher oder künstlicher Herkunft sein. Es kann sich z.B. um Naturharze, trocknende Oele oder Kautschuk handeln. Es kann sich aber auch um abgewandelte Naturstoffe handeln, beispielsweise um Chlorkautschuk, um ölmodifizierte Alkydharze oder um Cellulosederivate, wie Celluloseester oder Celluloseäther, und besonders um vollsynthetische organische Polyplaste, das heisst um Kunststoffe, die durch Polymerisation, Polykondensation oder Polyaddition hergestellt sind. Aus der Klasse dieser Kunststoffe seien besonders folgende genannt:
Polyäthylen, Polypropylen, Polyisobutylen, Polystyrol, Polyvinylchlorid, Polyvinylidenchlorid, Polyvinylacetale, Polyacrylnitril, Polyacrylsäure- und Polymethacrylsäureester oder Polybutadien, sowie Copolymerisate davon, insbesondere ABS oder EVA; Polyester, insbesondere hochmolekulare Ester aromatischer Polycarbonsäuren mit polyfunktionellen Alkoholen; Polyamide, Polyimide, Polycarbonate, Polyurethane, Polyäther wie Polyphenylenoxid, Polyacetale, die Kondensationsprodukte von Formaldehyd mit Phenolen, die sogenannten Phenoplaste, und die Kondensationsprodukte von Formaldehyd mit Harnstoff, Thioharnstoff und Melamin, die sogenannten Aminoplaste; die unter dem Namen "Epoxyharze" bekannten Polyadditions- bzw. Polykondensationsprodukte von Epichlorhydrin mit Diolen oder Polyphenolen und ferner die als Lackharze verwendeten Polyester, und zwar sowohl gesättigte, wie z.B. Alkydharze, als auch ungesättigte, wie beispielsweise Maleinatharze. Es sei betont, dass nicht nur die einheitlichen Verbindungen, sondern auch Gemische von Polyplasten, sowie Mischkondensate und Mischpolymerisate, wie z.B. solche auf Basis von Butadien, erfindungsgemäss verwendet werden können.

Hochmolekulare organische Materialen in gelöster Form als Filmbildner oder Bindemittel für Lacke oder Druckfarben kommen auch in Frage, wie z.B. Leinölfirnis, Nitrocellulose, Alkydharze, Phenolharze, Melaminharze, Acrylharze und Harnstoff-Formaldehydharze, wobei die daraus erhaltenen Filme erfindungsgemäss beschriftet werden können. Für das erfindungsgemässe Verfahren besonders bevorzugt geeignete Kunststoffe sind lineare Polyester, Polystyrol, Polyäthylen, Polypropylen, ABS, Polyacetale, Polyphenylenoxid, Polyamid, Polycarbonat, Polymethylmethacrylat und Epoxyharze.

Als eine Verfärbung verursachender Zusatzstoff kommen anorganische, organische Pigmente und polymerlösliche Farbstoffe in Frage, welche vorzugsweise im nahen UV- und/oder sichtbaren oder nahen IR-Bereich absorbieren.

Unter sichtbarem Bereich versteht man den Bereich zwischen 0,38 $\mu$m und 0,78 $\mu$m, unter nahem IR-Bereich den Bereich zwischen 0,78 $\mu$m und 2 $\mu$m und unter nahem UV-Bereich den Bereich zwischen 0,25

μm und 0,38 μm. Besonders geeignet sind Zusatzstoffe, die im sichtbaren Bereich absorbieren.

Beispiele von anorganischen Pigmenten als eine Verfärbung verursachende Zusatzstoffe sind Weisspigmente wie Titandioxide (Anatas, Rutil), Zinkoxid, Antimontrioxid, Zinksulfid, Lithopone, basisches Bleicarbonat, basisches Bleisulfat oder basisches Bleisilikat, ferner Metalloxide wie Eisenoxide, Chromoxide, Nickelantimon-titanat, Chrom-antimon-titanat, Manganblau, Manganviolett, Kobaltblau, Kobaltchromblau, Kobaltnikkelgrau oder Ultramarinblau, Berlinerblau, Bleichromate, Bleisulfochromate, Molybdatorange, Molybdatrot, ferner Metallsulfide, wie Cadmiumsulfid, Arsendisulfid, Antimontrisulfid oder Cadmiumsulfoselenide, Zirkonsilikate, wie Zirkonvanadiumblau und Zirkonpräseodymgelb, ferner Russ oder Graphit in kleiner Konzentration.

Beispiele von organischen Pigmenten als Zusatzstoffe sind Azo-, Azomethin-, Methin-, Anthrachinon-, Indanthron-, Pyranthron-, Flavanthron-, Benzanthron-, Phthalocyanin-, Perinon-, Perylen-, Dioxazin-, Thioindigo-, Isoindolin-, Isoindolinon-, Chinacridon-, Pyrrolopyrrol- oder Chinophthalonpigmente, ferner Metallkomplexe von z.B. Azo-, Azomethin- oder Methinfarbstoffen, oder Metallsalze von Azoverbindungen.

Als polymerlösliche Farbstoffe eignen sich beispielsweise Dispersionsfarbstoffe, wie solche der Anthrachinonreihe, beispielsweise Hydroxy-, Amino-, Alkylamino-, Cyclohexylamino-, Arylamino-, Hydroxyamino- oder Phenylmercapto-anthrachinone, sowie Metallkomplexe von Azofarbstoffen, insbesondere 1:2-Chrom- oder Kobaltkomplexe von Monoazofarbstoffen, ferner Fluoreszenzfarbstoffe, wie solche aus der Cumarin-, Naphthalimid-, Pyrazolin-, Acridin-, Xanthen-, Thioxanthen-, Oxazin-, Thiazin- oder Benzthiazolreihe.

Die polymerlöslichen Farbstoffe werden bevorzugt in Kombination mit Füllern und/oder Pigmenten, insbesondere mit anorganischen Pigmenten wie Titandioxid eingesetzt.

Pigmente oder polymerlösliche Farbstoffe können erfindungsgemäss mit oder ohne Pigmentzusätzen verwendet werden. Es muss lediglich darauf geachtet werden, dass sie mit dem erfindungsgemäss verwendeten hochmolekularen organischen Material verträglich sind und dessen mechanische oder sonstige Eigenschaften nicht beeinträchtigen.

Geeignete Pigmentzusätze sind beispielsweise Fettsäuren mit mindestens 12 C-Atomen, wie Stearinsäure oder Behensäure, deren Amide, Salze oder Ester, wie Magnesiumstearat, Zinkstearat, Aluminiumstearat oder Magnesiumbehenat, ferner quartäre Ammoniumverbindungen, wie Tri($C_1$-$C_4$)-alkylbenzylammoniumsalze, Wachse, wie Polyäthylenwachs, Harzsäuren, wie Abietinsäure, Kolophoniumseife, hydriertes oder dimerisiertes Kolophonium, $C_{12}$-$C_{18}$-Paraffindisulfonsäuren oder Alkylphenole.

Erfindungsgemäss bevorzugt sind die metallhaltigen Pigmente, wie die anorganischen Pigmente und die Metallkomplexe von Azo-, Azomethin- oder Methinfarbstoffen.

Ebenfalls bevorzugt sind Azo-, Azomethin-, Methin-, Anthrachinon-, Phthalocyanin-, Perylen-, Dioxazin-, Thioindigo-, Isoindolin-, Isoindolinon-, Chinacridon- oder Pyrrolopyrrolpigmente.

Der eine Verfärbung verursachende Zusatzstoff liegt im erfindungsgemäss in Frage kommenden hochmolekularen organischen Material in Mengen von 0,001 bis 10 Gew.-%, insbesondere von 0,01 bis 3 Gew.-%, bezogen auf das hochmolekulare organische Material, vor.

Die Zugabe des eine Verfärbung verursachenden Zusatzstoffes zu dem zu Formteilen zu verarbeitenden hochmolekularen organischen Material erfolgt nach an sich bekannten Methoden, beispielsweise derart, dass man einen solchen Zusatzstoff gegebenenfalls in Form von Masterbatches, diesem Substrat unter Verwendung von Extrudern, Walzwerken, Misch- oder Mahlapparaten zumischt. Das erhaltene Material wird hierauf nach an sich bekannten Verfahren wie Kalandrieren, Pressen, Strangpressen, Streichen, Giessen, Extrudieren oder durch Spritzguss in die gewünschte endgültige Form gebracht. Oft ist es erwünscht, zur Herstellung von nicht starren Formlingen oder zur Verringerung ihrer Sprödigkeit, den hochmolekularen organischen Verbindungen vor der Verformung sogenannte Weichmacher einzuverleiben. Als solche können z.B. Ester der Phosphorsäure, Phthalsäure oder Sebacinsäure dienen. Die Weichmacher können vor oder nach der Einverleibung des Zusatzstoffes in die Polymeren eingearbeitet werden.

Je nach Verwendungszweck können ferner dem hochmolekularen organischen Material noch weitere Stoffe zugefügt werden, wie beispielsweise Füllstoffe wie Kaolin, Glimmer, Feldspate, Wollastonit, Aluminiumsilikat, Bariumsulfat, Calciumsulfat, Kreide, Calcit und Dolomit, ferner Lichtschutzmittel, Antioxidantien, Flammschutzmittel, Hitzestabilisatoren, Glasfasern oder Verarbeitungshilfsmittel, welche bei der Verarbeitung von Kunststoffen üblich und dem Fachmann bekannt sind.

Zur Herstellung der erfindungsgemäss in Frage kommenden Lacke und Druckfarben werden die hochmolekularen organischen Materialien und der eine Verfärbung verursachende Zusatzstoff gegebenenfalls zusammen mit weiteren Lack- und Druckfarbenzusätzen, in einem gemeinsamen organischen Lösungsmittel oder Lösungsmittelgemisch fein dispergiert bzw. gelöst. Man kann dabei so verfahren, dass man die einzelnen Komponenten für sich oder auch mehrere gemeinsam dispergiert bzw. löst, und erst hierauf alle Komponenten zusammenbringt. Der homogenisierte Lack bzw. die Druckfarbe wird dann auf einem Substrat nach an sich bekannten Verfahren aufgetragen und eingebrannt bzw. getrocknet, und der erhaltene Lack- bzw. Druckfarbenfilm dann erfindungsgemäss beschriftet.

Zur Beschriftung der erfindungsgemäss in Frage kommenden hochmolekularen organischen Materialien werden energiereiche Quellen wie Laser verwendet. Dabei wird die Energiestrahlung entsprechend der Form des aufzubringenden Schriftzeichens auf die Oberfläche des zu markierenden Materials gerichtet, gegebenenfalls fokussiert, wobei an den bestrahlten Stellen eine Verfärbung entsteht, ohne dass die Oberfläche des beschrifteten Materials von Auge erkennbar beschädigt wird.

Beispiele für solche Quellen sind Festkörper-Pulslaser wie Rubinlaser oder frequenzvervielfachter Nd:YAG-Laser, gepulste Laser mit Zusatzeinrichtung wie gepulster Farbstofflaser oder Ramanshifter, weiter Dauerstrichlaser mit Pulsmodifikationen (Q-Switch, Mode-Locker), beispielsweise auf Basis von CW Nd:YAG-Laser mit Frequenzvervielfacher oder CW Ionen-Laser (Ar, Kr), ferner gepulste Metalldampflaser, wie beispielsweise Cu-Dampflaser oder Au-Dampflaser, oder allenfalls leistungsstarke gepulste Halbleiter-Laser.

Je nach eingesetztem Laser-System sind Pulsenergien bis einige Joule, Leistungsdichten bis Terawatt pro cm², Pulsbreiten bis Femto-Sekunden und Repetitionsraten bis Gigahertz möglich. Vorteilhafterweise eingesetzt werden Pulsenergien von Microjoule bis Joule, Leistungsdichten von Kilowatt pro cm² bis 100 Megawatt pro cm², Pulsbreiten von Micro-Sekunden bis Pico-Sekunden und Repetitionsraten von Hertz bis 250 Megahertz.

Bevorzugt werden Laser mit gepulstem Licht verwendet, wie beispielsweise in der nachstehenden Tabelle aufgeführt. Besonders bevorzugt sind gepulste oder pulsmodifizierte frequenzverdoppelte Nd-YAG-Laser oder Metall-Dampflaser wie Au- oder insbesonders Cu-Dampflaser.

In der folgenden Tabelle sind einige handelsübliche Laser aufgeführt, die erfindungsgemäss in Frage kommen können.

Tabelle

| Art/Vertreter | Kommerzielles Beispiel | Hauptwellenlänge (Nebenwellenlängen) [nm] |
|---|---|---|
| **Festkörper-Pulslaser**<br>• Rubinlaser<br><br>• Nd:YAG-Laser<br><br>• Alexandrite-Laser | Lasermetrics (938R6R4L-4)<br>Quanta Ray (DCR 2A)<br>Apollo (7562) | 694 (347)<br><br>1064, (532 355,266)<br>730-780 |
| **Gepulste Laser mit Zusatzeinrichtung** wie<br>• Raman-Shifter<br><br>• Farbstofflaser | Quanta Ray (RS-1)<br>Lambda Physik FL 2002 | UV-IR<br><br>ca.300-1000 |
| **CW-Laser mit Pulsmodifikation**<br>• Nd:YAG (Q-Switch,2ω)<br><br>• Argon (mode-locked) | Lasermetrics (9560QTG)<br>Spectra-Physics | 532<br><br>514,5 |
| **Gepulste Metalldampflaser**<br>• Cu-Dampflaser<br><br>• Au-Dampflaser<br><br>• Mn-Dampflaser<br>• Pb-Dampflaser | Plasma-Kinetics 751<br>Plasma-Kinetics<br>} Oxford<br>} Laser CU 25 | 510,578<br><br>628<br><br>534, 1290<br>723 |
| **Halbleiter Diodenlaser**<br><br>"  Array | M/A COM Typ LD 65<br>STANTEL Typ LF 100 | 905<br><br>905 |

Gemäss dem erfindungsgemässen Verfahren wird beispielsweise mit einem gepulsten frequenzverdoppelten Nd:YAG-Laser mit circa 250 Millijoule pro cm² Pulsenergie, etwa 40 Megawatt Spitzenleistung, 6-8 Nano-Sekunden Pulsbreiten und 20 Hertz Repetitionsrate (Modell Quanta Ray DCR-2 A der Firma Spectra Physics, Mountain View, California) gearbeitet.

Verwendet man einen Cu-Dampflaser (Plasma Kinetics Modell 151), so wird beispielsweise mit 250 Millijoule pro cm² Pulsenergie, etwa 10 Kilowatt Spitzenleistung, 30 Nano-Sekunden Pulsbreite und 6 Kilohertz Repetitionsrate belichtet.

Laser mit guter Einstellbarkeit ihrer Laserparameter wie beispielsweise Pulsenergie und Einwirkzeit erlauben eine optimale Anpassung an die Bedürfnisse der zu beschriftenden Materialien.

Die optimale, zur Bestrahlung auszuwählende Wellenlänge ist diejenige, bei welcher der eine Verfärbung verursachende Zusatzstoff am meisten, das hochmolekulare organische Material dagegen am wenigsten absorbiert.

Zur Beschriftung mit Lasern kommen drei verschiedene Verfahren in Frage: das Maskenverfahren, die linienförmige Beschriftung und das Punkt-Matrix-Verfahren. Bei den zwei letztgenannten Beschriftungsarten (dynamische Strahlführung) wird der Laser bevorzugt mit einem Laserbeschriftungssystem gekoppelt, so dass das hochmolekulare organische Material mit beliebigen, beispielsweise in einem Computer programmierten Ziffern, Buchstaben und Sonderzeichen an der Auftreffstelle des Laserstrahls beschriftet werden kann.

Die Wahl des Lasersystems bezüglich Leistung und Repetitionsrate richtet sich grundsätzlich nach dem zur Anwendung gelangenden Beschriftungsverfahren. Hohe Leistung und niedere Repetitionsrate wie beim Festkörper-Pulslaser werden bevorzugt für Maskenbelichtungen angewandt. Mittlere bis kleine Leistungen und schnelle Repetitionsraten beim gepulsten Metalldampflaser oder wie beim Dauerstrichlaser mit Pulsmodifikationen werden bevorzugt für Beschriftungen angewandt, die eine dynamische Strahlführung erfordern. Die Strahlablenkung kann beispielsweise akustooptisch, holographisch, mit Galvo-Spiegeln oder Polygon-Scannern erfolgen. Die dynamische Strahlführung erlaubt eine äusserst flexible Beschriftung oder Markierung, da die Zeichen elektronisch erzeugt werden können.

Nach dem erfindungsgemässen Verfahren können die verschiedensten Beschriftungsarten erhalten werden. Beispiele hierfür sind: Variable Textprogrammierung von numerischen Zeichen mittels der Texteingabe mit einem Bildschirmterminal, Testprogramme von Standardzeichen oder Sonderzeichen wie Namenszüge, Signete oder sich oft wiederholende Daten, fortlaufende Stückzahlnumerierung, Eingabe von Messgrössen, Eingabe eines gespeicherten Programms, Linienbeschriftung oder auch Dekorationen.

Nach dem erfindungsgemässen Verfahren können die verschiedensten Kunststoffteile oder -formen sowie Lack- und Druckfarben-Filme beschriftet werden. Beispiele hierfür sind Bänder, Tafeln, Rohre und Profile, Tasten und mit Kunststoff umhüllte elektronische Bauteile.

Typische Anwendungsbeispiele sind die Beschriftung von Schaltungen, Leiterplatten, gedruckten Schaltungen, aktiven und passiven elektronischen Komponenten, enkapsulierten Hochspannungstransformatoren, Steckdosen, Gehäusen, mechanischen Bestandteilen aus der Feintechnik und der Uhrenindustrie, Fahrzeugbestandteilen, Tastaturen, elektronischen Bauteilen, Kabeln, Rohren, Lacken, Folien und Verpackungsfolien, sowie Banknoten und Wertschriften.

Das erfindungsgemässe Verfahren ermöglicht eine Markierung, welche nicht verwischt werden kann und daher abrieb- und kratzfest ist. Die erfindungsgemäss erhaltenen Markierungen sind ferner korrosionsbeständig, dimensionsstabil, deformationsfrei, licht-, hitze- und wetterbeständig, gut lesbar und mit sauberen Randzonen. Ferner werden die mechanischen und physikalischen Eigenschaften des so beschrifteten Materials praktisch nicht beeinträchtigt. Die Eindringtiefe der Markierung hängt vom beschrifteten Material ab. Sie beträgt bis ca. 1 mm. Das hochmolekulare organische Material wird dabei weitgehendst geschont. Es sind somit Beschriftungen möglich, die keinen von Auge erkennbaren Verlust am Oberflächenglanz bewirken.

Gemäss dem vorliegenden Verfahren tritt unter Laserbestrahlung an der bestrahlten Stelle des Materials ein Farbumschlag mit einem ausgeprägten Kontrast ein. Meistens entsteht ein Farbumschlag nach schwarz. Es ist aber auch möglich, je nach verwendetem, eine Verfärbung verursachendem Zusatzstoff, andere Verfärbungen zu erzeugen, so beispielsweise von rot oder gelb zu braun, von rot oder gelb zu weiss, oder von schwarz zu weiss.

Mit dem erfindungsgemässen Verfahren können semitransparente Platten und Folien auf eine besonders attraktive Art beschriftet werden, dadurch charakterisiert, dass die Beschriftung in der Aufsicht opak erscheint, jedoch in der Durchsicht in einer Nuance der Ausgangsfarbe vor der Beschriftung nahezu transparent wird. Der Kontrast in Aufsicht wie auch die Nuance der Transparenz können auf einfache Weise durch Anpassung der Laserpulsparameter kontrolliert werden.

In den folgenden Beispielen bedeuten Teile, sofern nicht anders angegeben, Gewichtsteile.

Beispiel 1:

a) Umhüllung von Metallplättchen mit Sinterpulvern

Stahlplättchen der Grösse 40 x 40 x 2 mm, die entfettet, jedoch nicht entgratet sind, werden in einem Ofen auf 120°C erwärmt. Anschliessend werden die Plättchen rasch für 3 Sekunden in ein Wirbelbett mit an und für sich bekannten Epoxyharz-Sinterpulvern [z.B. Gemisch enthaltend 38 Teile eines vorverlängerten Epoxidharzes auf der Basis von Bisphenol A mit einem Epoxidgehalt von 1,3 Aequivalenten/kg, 14 Teile eines bromhaltigen Epoxidharzes auf der Basis von tetrabromiertem Bisphenol A mit einem Epoxidgehalt von 2,0 bis 2,2 Aequivalenten/kg, 4,5 Teile eines Verlaufsmittels auf Acrylatbasis, 5,8 Teile Benzophenonetetracarbonsäuredianhydrid als Härter, 29,5 Teile $Al_2O_3.3H_2O$ und 18,5 Teile Quarzmehl als Füllstoffe, 0,3 Teile Kieselsäure Aerosil® 380 der Firma Degussa, Deutschland und 1,3 Teile Imidazol als Beschleuniger] und 2 Teilen des eine Verfärbung verursachenden Zusatzstoffs getaucht. Dieser Vorgang mit Erwärmen und Tauchen wird einmal wiederholt. Dabei wird eine glänzende, flammhemmende Umhüllung mit einer Schichtdicke von 250-400 μm erreicht. Zur vollständigen Aushärtung werden die beschichteten Plättchen für 15 Minuten bei 180°C gelagert.

b) Beschriftung

Nach dem obigen allgemeinen Verfahren beschichtete Stahlplättchen und enthaltend als eine Verfärbung verursachenden Zusatz 1,8 Gew.-% C.I. Pigment Violett 19 (Chinacridon) werden nun im Strahlengang eines Nd:YAG-Pulslasers (Modell Quanta Ray DCR-2A der Firma Spectra Physics, Mountain View, USA) durch Lichtpulse von 6-8 ns (ns = Nano-Sekunde) der Wellenlänge 0,532 μm (frequenzverdoppelter Strahl) und 120 mJ (mJ = Millijoule) Pulsenergie bestrahlt. Es entsteht eine intensive schwarze Beschriftung der Epoxyplättchen, ohne dass dabei die Oberfläche von Auge erkennbar verletzt wird.

Beispiel 2:

99,7 g Polybutylenterephthalat [Crastin® S 600 (Firma Ciba-Geigy, Schweiz), im folgenden als PBTP abgekürzt] werden mit 0,3 g eines roten Eisenoxydpigmentes (Bayferrox® 140 der Firma Bayer, Deutschland, C.I. Pigment Rot 101) gemischt und in einer Spritzgussmaschine bei 250°C Zylindertemperatur, 80°C Werkzeugtemperatur und 40 Sekunden Zykluszeit zu Plättchen der Grösse 4 x 5 cm (Dicke: 3 mm) geformt. Diese Plättchen werden analog dem Beispiel 1b mit dem Nd:YAG-Pulslaser bestrahlt. Es entsteht eine schwarze Beschriftung, die nach 250-stündiger Weathereometerbelichtung (Zyklus 45°) keinen Farbumschlag aufweist.

Beispiel 3:

Analog dem Beispiel 1, jedoch unter Verwendung von 2 g C.I. Pigment Gelb 139 (Isoindolin) als eine Verfärbung verursachender Zusatzstoff hergestellte Epoxy-Plättchen werden gemäss Beispiel 1b mit gutem Kontrast dunkelbraun beschriftet.

Beispiel 4:

Analog dem Beispiel 1, jedoch unter Verwendung von 2 g Irgazin® Rot BPT [Perylenrot der Firma Ciba-Geigy, Schweiz, C.I. Pigment Rot 224] als eine Verfärbung verursachender Zusatzstoff hergestellte Epoxyplättchen werden nach dem im Beispiel 1b angegebenen Verfahren mit gutem Kontrast schwarz beschriftet.

Beispiel 5:

Analog dem Beispiel 2, jedoch mit 0,3 g eines Chromgelbpigmentes (Chromgelbpigment® GMN 35 der Firma Ciba-Geigy, Schweiz, C.I. Pigment Gelb 34) als eine Verfärbung verursachender Zusatzstoff versehene PBTP-Plättchen werden gemäss Beispiel 1b mit gutem Kontrast schwarz beschriftet.

Beispiel 6:

Setzt man gemäss Beispiel 2, 0,2 g eines Cadmiumrotpigmentes (Cadmium® Rot conc. X-2948 der Firma Ciba-Geigy Schweiz, C.I. Pigment Rot 108) anstatt 0,3 g eines Eisenoxydpigmentes ein, so lassen sich die so erhaltenen PBTP-Plättchen mittels Laserbestrahlung gemäss Beispiel 1b mit gutem Kontrast schwarz beschriften.

Beispiel 7:

Analog dem Beispiel 2, jedoch mit 0,15 g eines Molybdatrotpigmentes (Molybdat Rot® AA-3 der Firma Ciba-Geigy, Schweiz, C.I. Pigment Rot 104) als eine Verfärbung verursachender Zusatzstoff hergestellte PBTP-Plättchen ergeben bei Laserbestrahlung gemäss Beispiel 1b mit geringer Intensität ($\leq$ 50 mJ/cm$^2$) ein gelbes Schriftbild, bei Laserbestrahlung mit stärkerer Intensität (> 50 mJ/cm$^2$) dagegen ein schwarzes Schriftbild.

Beispiel 8:

7

Analog dem Beispiel 2, jedoch mit 8 g weissem Antimontrioxid als eine Verfärbung verursachender Zusatzstoff hergestellte PBTP-Plättchen ergeben bei Laserbebestrahlung gemäss Beispiel 1b ein schwarzes Schriftbild.

Beispiel 9:

30 g einer 55 Gew.-%igen Lösung eines Alkydharzes und eines Melaminformaldehydharzes, [Gemisch aus 67,5 g einer 60 Gew.-%igen Lösung eines Alkydharzes in Xylol (Handelsname Alkydal® F27 der Firma Bayer, Deutschland), 26,4 g einer 55 Gew.-%igen Lösung eines Melamin-Formaldehyd-Harzes in einem Butanol-Xylol-1:1-Gemisch (Handelsname Maprenal® MF 590 der Firma Casella, Deutschland), 1,1 g Xylol, 4,0 g Aethylenglykol, 1,0 g Siliconoel® A (1 % in Xylol) der Firma Bayer, Deutschland, und 2 g Methylcellosolve], 8 g Methylisobutylketon und 2 g Molybdat-Rot® AA-3 (Firma Ciba-Geigy, Schweiz, C.I. Pigment Orange 104) als eine Verfärbung verursachender Zusatzstoff werden in einer 100 ml-Glasflasche mit Schraubdeckel enthaltend 135 g Glasperlen von 3,5 mm Durchmesser vermischt und während 16 Stunden mit einer Laborschwingmühle dispergiert. Der so erhaltene Lack wird dann nach üblichen Methoden mit einem Ausziehgerät auf 150 μm Nassfilmdicke auf Blech und auf einem in der Lackindustrie handelsüblichen Schwarz-Weiss-Kontrastkarton ausgezogen und 30 Minuten bei 130° C eingebrannt. Die erhaltenen Lackierungen werden dann gemäss Beispiel 1b bestrahlt. Es entsteht in beiden Fällen eine graue Beschriftung, ohne dass dabei die Oberfläche der Lackierungen von Auge erkennbar verletzt wird.

Beispiel 10:

Analog dem Beispiel 9, jedoch unter Verwendung von 2 g Cadmium Gelb® X-2822 (Cadmiumpigment der Firma Ciba-Geigy, Schweiz, C.I. Pigment Gelb 35) anstelle von 2 g Molybdat-Orange hergestellte Lackierungen auf Blech und auf Schwarz-Weiss-Kontrastkarton werden gemäss Beispiel 1b in beiden Fällen mit gutem Kontrast schwarz beschriftet.

Beispiel 11:

Analog dem Beispiel 9, jedoch unter Verwendung von 2 g Bayferrox® 140 M (Eisenoxydrotpigment der Firma Bayer, Deutschland, C.I. Pigment Rot 101) anstelle von Molybdat-Rot hergestellte Lackierungen auf Blech und auf Schwarz-Weiss-Kontrastkarton werden gemäss Beispiel 1b in beiden Fällen mit gutem Kontrast grau beschriftet.

Beispiel 12:

30 g der in Beispiel 9 angegebenen 55 Gew.-%igen Lösung eines Alkydharzes und eines Melaminharzes, 8 g Methylisobutylketon, 7,6 g Titandioxid (Bayer Titan® RKB 3 der Firma Bayer, Deutschland) und 0,4 g Molybdatrot® AA-3 (Firma Ciba-Geigy, Schweiz) als eine Verfärbung verursachender Zusatzstoff werden in einer 100 ml-Glasflasche mit Schraubdeckel enthaltend 135 g Glasperlen von 3,5 mm Durchmesser vermischt und während 16 Stunden mit einer Laborschwingmühle dispergiert. Der so erhaltene Lack wird dann nach üblicher Methode mit einem Ausziehgerät auf 150 μm Nassfilmdicke auf Blech und auf einem in der Lackindustrie handelsüblichen Schwarz-Weiss-Kontrastkarton ausgezogen und 30 Minuten bei 130° C eingebrannt. Die erhaltenen Lackierungen werden dann gemäss Beispiel 1b bestrahlt. Es entsteht eine graue Beschriftung.

Beispiel 13:

Analog dem Beispiel 12, jedoch unter Verwendung von 2 g Cadmium® Gelb X-2822 (C.I. Pigment Gelb 35, Firma Ciba-Geigy, Schweiz) anstelle von 0,4 g Molybdatrot hergestellte Lackierungen auf Blech und auf Schwarz-Weiss-Kontrastkarton werden gemäss Beispiel 1b in beiden Fällen mit gutem Kontrast grau beschriftet.

Beispiel 14:

Analog dem Beispiel 12, jedoch unter Verwendung von 2 g Bayferrox® 140 M (Eisenoxydrotpigment der Firma Bayer, Deutschland) anstelle von 0,4 g Molybdatrot hergestellte Lackierungen auf Blech und auf Schwarz-Weiss-Kontrastkarton werden gemäss Beispiel 1b in beiden Fällen mit gutem Kontrast hell-blau beschriftet.

Beispiel 15:

Analog dem Beispiel 12, jedoch unter Verwendung von 2 g Filester® Gelb 2648 A (Anthrachinonderivat der Firma Ciba-Geigy, Schweiz, C.I. Pigment Gelb 147) anstelle von 0,4 g Molybdatrot hergestellte Lackierungen auf Blech und auf Schwarz-Weiss-Kontrastkarton werden gemäss Beispiel 1b in beiden Fällen grau beschriftet.

Beispiel 16:

Verfährt man analog dem Beispiel 2, verwendet aber an Stelle von Laserlicht der Wellenlänge 0,532 µm Laserlicht der Wellenlänge 355 nm (verdreifachte Frequenz eines Nd:YAG-Lasers, Quanta Ray Modell DCR-2A der Firma Spectra Physics, USA) mit Pulsen von 6-8 ns Dauer und 50 mJ Pulsenergie, und fokussiert die Strahlung durch eine Glaslinse mit der Brennweite 250 mm auf einen Strahldurchmesser von 1 - 2 mm, so entsteht eine schwarze Beschriftung.

Beispiel 17:

Wiederholt man das Beispiel 5, beschriftet aber mit Laserlicht der Wellenlänge 355 nm (verdreifachte Frequenz eines Nd:YAG-Lasers, Quanta Ray Modell DCR-2A der Firma Spectra Physics, USA) mit Pulsen von 6-8 ns Dauer und 50 mJ Pulsenergie, und fokussiert die Strahlung durch eine Glaslinse mit der Brennweite 250 mm auf einen Strahldurchmesser von 1-2 mm, so werden schwarze Beschriftungen mit gutem Kontrast erhalten.

Beispiel 18:

Analog dem Beispiel 7, jedoch unter Bestrahlung mit Laserlicht der Wellenlänge 355 nm (verdreifachte Frequenz eines Nd:YAG-Lasers, Quanta Ray Modell DCR-2A der Firma Spectra Physics, USA) mit Pulsen von 6-8 na Dauer und 50 mJ Pulsenergie, und unter gleichzeitiger Fokussierung der Strahlung durch eine Glaslinse mit der Brennweite 250 mm auf einen Strahldurchmesser von 1-2 mm, wird ein graues Schriftbild erhalten.

Beispiel 19:

Analog dem Beispiel 7, jedoch wird unter Bestrahlung mit Laserlicht der Wellenlängen 511 und 578 nm eines Kupferdampf-Lasers (Plasma Kinetics Modell 151 der Firma Plasma Kinetics, USA) mit Pulsen von 20-60 na Dauer und 0,5 mJ Pulsenergie, beschriftet. Dazu wird die Strahlung durch eine Glaslinse mit der Brennweite 250 mm auf einen Strahldurchmesser von 0,5 - 1 mm verwendet. Bei 0,5 mm Strahldurchmesser wird eine graue Markierung mit gelbem Rand, bei 1 mm Strahldurchmesser dagegen eine gelbe Markierung erzielt.

Beispiel 20:

Analog dem Beispiel 5, jedoch wird unter Bestrahlung mit Laserlicht der Wellenlängen 511 und 578 nm eines Kupferdampf-Lasers (Plasma Kinetics Modell 151 der Firma Plasma Kinetics, USA) mit Pulsen von 20-60 na Dauer und 0,5 mJ Pulsenergie beschriftet. Dazu wird die Strahlung durch eine Glaslinse mit der Brennweite 250 mm auf einen Strahldurchmesser von 0,5 - 1 mm fokussiert. Dabei werden PBTB-Plättchen mit gutem Kontrast schwarz beschriftet.

Beispiel 21:

Analog dem Beispiel 2, jedoch unter Bestrahlung mit Laserlicht der Wellenlängen 511 und 578 nm eines Kupferdampf-Lasers (Plasma Kinetics Modell 151 der Firma Plasma Kinetics, USA) mit Pulsen von 20-60 ns Dauer und 0,5 mJ Pulsenergie wird beschriftet. Dazu wird die Strahlung durch eine Glaslinse mit der Brennweite 250 mm auf einen Strahldurchmesser von 1 - 2 mm fokussiert. Dabei werden PBTB-Plättchen schwarz beschriftet.

Beispiel 22:

10 Teile eines PVC-Copolymers mit einem Vinylacetatanteil von 10 % (Vinylite VYNS® der Firma Union Carbide) wird in ein Lösungsmittelgemisch (77 Teile Methyläthylketon/Methylisobutylketon 1:1, 10 Teilen Toluol) eingerührt und aufgelöst. Darauf werden 8 Teile eines gelben Azo-Kondensationspigmentes (Mikrolith® gelb 3G-K der Firma Ciba-Geigy, Basispigment C.I. Pigment Gelb 93) eingerührt und anschliessend in einem Dissolver während 15 min. bei 6000 UPM dispergiert. Die erhaltene Pigmentdispersion wird als Druckfarbe für weiss pigmentierte Weich-PVC-Folien mit einem Weichmachergehalt von ca. 35 % verwendet. Die im Tiefdruckverfahren bei Aetztiefen von 4, 8, 15, 28, 40 und 45 μm bedruckten Folien werden nach dem in Beispiel 1a beschriebenen Verfahren mit gutem Kontrast grau beschriftet.

Beispiel 23:

99,7 g Acryl-Butadienstyrol (Terluran® 84BS, Firma BASF, Deutschland) werden mit 0,3 g eines roten Eisenoxydpigments (Bayferrox® 140 der Firma Bayer, Deutschland, C.I. Pigment Rot 101) gemischt und in einer Spritzgussmaschine bei 200-230° C Zylindertempeatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 24:

Analog dem Beispiel 2, jedoch mit 0,15 g eines Cu-Phthalocyaninpigmentes (Mikrolith® Grün G-FP der Firma Ciba-Geigy, Schweiz, Basispigment C.I. Pigment Grün 7) als eine Verfärbung verursachender Zusatzstoff versehene PBTP-Plättchen werden mit der Grundfrequenz (1064 nm) eines Nd:YAG-Lasers, Quanta Ray Modell DCR-2A der Firma Spectra Physics, USA) mit Pulsen von 6-8 ns Dauer und 250 mJ Pulsenergie schwarz beschriftet.

Beispiel 25:

Analog dem Beispiel 24, jedoch mit 0,3 g Filester® Gelb 2648A (Anthrachinonderivat der Firma Ciba-Geigy, Schweiz, C.I. Pigment Gelb 147) als eine Verfärbung verursachender Zusatzstoff versehene PBTB-Plättchen werden mit gutem Konstrast schwarz beschriftet, wobei im vorliegenden Fall 500 mJ Pulsenergie anstelle von 250 mJ Pulsenergie eingesetzt wird.

Beispiel 26:

Analog dem Beispiel 24, jedoch mit Laserlicht der Wellenlängen 511 und 578 nm eines Kuperfdampf-Lasers, (Plasma Kinetics Modell 151 der Firma Plasma Kinetics, USA) mit Pulsen von 20-60 ns Dauer und 0.5 mJ Pulsenergie werden PBTB-Plättchen bestrahlt. Dazu wird die Strahlung durch eine Glaslinse mit der Brennweite 250 mm auf einen Strahldurchmesser von 0,5 mm fokussiert und erzeugt eine schwarze Beschriftung.

Beispiel 27:

99,7 g Polycarbonat (Makrolon® 2800, Firma Bayer, Deutschland) werden mit 0,3 g eines gelben Cadmium-Pigments® (Cadmium Gelb X-2822 der Firma Ciba-Geigy, C.I. Pigment Gelb 35) gemischt und in einer Spritzgussmaschine bei 260-280° C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 28:

99,7 g Polyoxymethylen (Hostaform® C 9020, Firma Hoechst, Deutschland) werden mit 0,3 g eines gelben Pigments (Filester® Gelb 2648 A der Ciba-Geigy, Schweiz, C.I. Pigment Gelb 147) gemischt und in einer Spritzgussmaschine bei 190-210° C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 29:

99,7 g HD-Polyäthylen (Lupolen® 1030 K, Firma BASF, Deutschland) werden mit 0,3 g eines roten Eisenoxydpigments (Bayferrox® 140 der Firma Bayer, Deutschland, C.I. Pigment Rot 101) gemischt und in einer Spritzgussmaschine bei 190-230°C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 30:

99,7 g Polyamid 12 (Vestamid®L 1901 der Firma Chem. Werke Hüls, Deutschland) werden mit 0,3 g eines gelben Anthrachinon-Pigments (Filester® Gelb 2648 A der Firma Ciba-Geigy, Schweiz, C.I. Pigment Gelb 147) gemischt und in einer Spritzgussmaschine bei 210-250°C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 31:

99,7 g Polyamid 66 (Ultramid® A3K der Firma BASF, Deutschland) werden mit 0,3 g eines gelben Anthrachinon-Pigments (Filester® Gelb 2648 A der Firma Ciba-Geigy, Schweiz, C.I. Pigment Gelb 147) gemischt und in einer Spritzgussmaschine bei 250-280°C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 32:

100 g Polyvinylchlorid (Vestolit®S 6558 der Firma Chem. Werke Hüls, Deutschland), 1,2 g Irgastab® 17 M (Butylzinnschwefel-Stabilisator der Firma Ciba-Geigy, Schweiz), 0,4 g Irgawax® 361 (Gleitmittel, Glycerin-monooleat der Firma Ciba-Geigy, Schweiz) und 0,2 g Wachs® E (Firma Hoechst, Montansäureesterwachs) werden mit 0,3 g eines gelben Anthrachinon-Pigments (Filester® Gelb 2648 A der Firma Ciba-Geigy, Schweiz, C.I. Pigment Gelb 147) gemischt und auf einem Zweiwalzenmischwerk 8 Minuten lang bei einer Walzentemperatur von 160°C gewalzt. Das gefärbte Hart-PVC-Fell wird von der Walze abgezogen und 5 Minuten lang bei 160°C auf einer Etagenpresse zu Platten verpresst. Die so erhaltenen Platten werden analog dem Beispiel 1b mit dem Nd:YAG-Pulslaser bestrahlt. Es entsteht eine schwarze Beschriftung mit gutem Kontrast.

Beispiel 33:

99,7 g Polystyrol (Polystyrol® 143 E der Firma BASF, Deutschland) werden mit 0,3 g eines roten Eisenoxydpigments (Bayferrox® 140 der Firma Bayer, Deutschland, C.I. Pigment Rot 101) gemischt und in einer Spritzgussmaschine bei 200-240°C Zylindertemperatur zu Plättchen der Grösse 4 x 5 cm (Dicke 3 mm) geformt. Diese Plättchen werden analog dem Beispiel 1b mit dem Nd:YAG-Pulslaser bestrahlt. Es entsteht eine schwarze Beschriftung mit gutem Kontrast.

Beispiel 34:

Für das Einfärben von Epoxy-Massen wird eine Farbpaste aus 85 g Epoxidbasisharz AY 105® (Firma Ciba-Geigy, Schweiz), 1,5 g eines gelben Azo-Kondensationspigmentes (Cromophtalgelb®3G, C.I. Pigment Gelb 93) und 13,5 g eines roten Azo-Kondensationspigmentes (Cromophtalrot® G, C.I. Pigment Rot 220, beide Ciba-Geigy, Schweiz) hergestellt. 1 g dieser Farbpaste wird mit 24 g eines aliphatischen Amins® HY 956 (Firma Ciba-Geigy, Schweiz) und 100 g Epoxidbasisharz® AY 105 (Firma Ciba-Geigy) vermischt und zu Platten von 1 mm Dicke gegossen. Die Platten werden während 3-4 Std. bei 40-50°C ausgehärtet. Beim Bestrahlen dieser Platten mit Laserlicht entsprechend dem Beispiel 1b, jedoch unter Bestrahlung mit einer Pulsenergie von 1 mJ und gleichzeitiger Fokussierung durch eine Glaslinse mit der Brennweite 250 mm auf einen Strahldurchmesser von 0,5 mm, entstehen Markierungen, die bei normaler Betrachtung mit Licht in der Beobachtungsrichtung schwarz erscheinen, bei Betrachtung gegen eine Lichtquelle aber gelblich transparent aussehen.

EP 0 190 997 B1

Beispiel 35:

65 g stabilisiertes Polyvinylchlorid, 35 g Dioctylphthalat und 0,2 g 1,4-Diketo-3,6-di-parachlorophenyl-pyrrolo[3,4-c]pyrrol (gemäss US Patent Nr. 4,415,685) werden miteinander verrührt und auf einem Zweiwalzenkalander 7 Minuten bei 160°C gewalzt. Man erhält eine rot gefärbte Folie. Diese Folie wird analog dem Beispiel 1b mit dem Nd:YAG-Pulslaser bestrahlt. Es entsteht eine schwarze Beschriftung mit gutem Kontrast.

Beispiel 36:

99,7 g Melaminharz (Melopas® N 37601 der Firma Ciba-Geigy AG, Schweiz) werden mit 0,3 g eines roten Pigments (Bayferrox® 1420 der Firma Bayer, Deutschland, C.I. Pigment Rot 101) gemischt und in einer Spritzgussmaschine bei 95°C Zylindertemperatur, 170°C Werkzeugtemperatur und 35 Sekunden Zykluszeit zu Stufen-Plättchen der Grösse 4 x 5 cm (Dicke 1-3 mm) geformt. Diese Plättchen werden analog dem Beispiel 1b mit dem Nd:YAG-Pulslaser bestrahlt. Es entsteht eine graue Beschriftung mit gutem Kontrast.

Beispiel 37:

98 g Polycarbonat-Granulat (Lexan® 101-111 der Firma General Electric Plastics BV, Holland) werden mit 0,25 g eines löslichen Anthrachinon-Farbstoffes (Oracet® Gelb GHS der Firma Ciba-Geigy Schweiz, C.I.Solvent Gelb 163) und 1,5 g TiO$_2$ (Typ CL 220 der Firma Kronos Titan GmbH) während 10 Min. trocken gemischt. Die Mischung wird bei einer Temperatur von 310°C im Spritzgussverfahren in Formen bei 80°C geformt, nochmals gemahlen und unter gleichen Bedingungen zu Plättchen von 1,5 x 6,5 cm (Dicke 1,5 mm) gegossen. Bei der Bestrahlung mit Laserlicht analog zu Beispiel 1b entstehen schwarze Markierungen mit gutem Kontrast.

**Patentansprüche**

1. Verfahren zur sichtbaren Beschriftung von zu Formteilen, Lack- und Druckfarbenfilmen verarbeitetem hochmolekularem organischem Material enthaltend mindestens einen strahlungsempfindlichen, eine Verfärbung verursachenden Zusatzstoff, wobei das hochmolekulare organische Material Naturharze, trocknende Oele, Kautschuk, Chlorkautschuk, ölmodifizierte Alkydharze, Cellulosederivat, Polyäthylen, Polypropylen, Polyisobutylen, Polystyrol, Polyvinylchlorid, Polyvinylidenchlorid, Polyvinylacetale, Polyacrylnitril, Polyacrylsäure- und Polymethacrylsäureester oder Polybutadien, sowie Copolymerisate davon, Polyester, Polyimide, Polycarbonate, Polyurethane, Polyäther, Polyacetale, die Kondensationsprodukte von Formaldehyd mit Phenolen, die sogenannten Phenoplaste, die Kondensationsprodukte von Formaldehyd mit Harnstoff, Thioharnstoff und Melamin, die sogenannten Aminoplaste, und die unter dem Namen "Epoxyharze" bekannten Polyadditions- bzw. Polykondensationsprodukte von Epichlorhydrin mit Diolen oder Polyphenolen ist, und wobei die Energiestrahlung entsprechend der Form des aufzubringenden Schriftzeichens auf die Oberfläche des zu markierenden Materials gerichtet wird und an den bestrahlten Stellen eine Verfärbung entsteht, dadurch gekennzeichnet, dass man als Energiestrahlung Laserlicht, dessen Wellenlänge im UV-Bereich zwischen 0,25 und 0,38 μm und/oder im sichtbaren Bereich und/oder im IR-Bereich zwischen 0,78 und 2 μm liegt, und als eine Verfärbung verursachender Zusatzstoff mindestens ein anorganisches und/oder organisches Pigment und/oder einen polymerlöslichen Farbstoff verwendet, ohne dass die Oberfläche des beschrifteten Materials von Auge erkennbar beschädigt wird.

2. Verfahren gemäss Anspruch 1, dadurch gekennzeichnet, dass man einen Laser mit gepulstem Licht verwendet.

3. Verfahren gemäss Anspruch 1, dadurch gekennzeichnet, dass man einen Laserstrahl mit einer Wellenlänge des sichtbaren und/oder nahen IR-Bereiches verwendet.

4. Verfahren gemäss Anspruch 1, dadurch gekennzeichnet, dass man einen gepulsten oder pulsmodifizierten frequenzverdoppelten Nd: YAG-Laser oder einen Metall-Dampflaser verwendet.

5. Verfahren gemäss Anspruch 1, dadurch gekennzeichnet, dass man als hochmolekulares organisches

12

Material Polyäthylen, Polypropylen, Polyisobutylen, Polystyrol, Polyvinylchlorid, Polyvinylidenchlorid, Polyvinylacetale, Polyacrylnitril, Polyacrylsäure- und Polymethacrylsäureester, Polybutadien, ABS- oder EVA-Copolymerisate, Polyester, Polyamide, Polyimide, Polycarbonate, Polyurethane, Polyäther, Polyacetale, Phenoplaste, Aminoplaste und Epoxyharze verwendet.

6. Verfahren gemäss Anspruch 1, dadurch gekennzeichnet, dass man als hochmolekulares organisches Material einen linearen Polyester, Polystyrol, Polyäthylen, Polypropylen, ABS, ein Polyacetal, Polyphenylenoxid, Polyamid, Polycarbonat, Polymethylmethacrylat oder ein Epoxyharz verwendet.

7. Verfahren gemäss Anspruch 1, dadurch gekennzeichnet, dass man als Zusatzstoff ein metallhaltiges Pigment aus der Reihe der anorganischen Pigmente und der Metallkomplexe von Azo-, Azomethin- oder Methinfarbstoffen verwendet.

8. Verfahren gemäss Anspruch 1, dadurch gekennzeichnet, dass man als Zusatzstoff einen polymerlöslichen Farbstoff mit einem anorganischen Pigment verwendet.

9. Verfahren gemäss Anspruch 8, dadurch gekennzeichnet, dass man als anorganisches Pigment Titandioxid verwendet.

10. Verfahren gemäss Anspruch 1, dadurch gekennzeichnet, dass man als Zusatzstoff ein Azo-, Azomethin-, Methin-, Anthrachinon-, Phthalocyanin-, Perylen-, Dioxazin-, Thioindigo-, Isoindolin-, Isoindolinon-, Chinacridon- oder Pyrrolopyrrolpigment verwendet.

11. Verwendung des eine Verfärbung verursachenden Zusatzstoffes zur Laserbeschriftung von hochmolekularem organischem Material gemäss Anspruch 1.

**Claims**

1. A method for the visible inscription of high molecular weight organic material which is processed to give mouldings or surface-coating and printing ink films and which contains at least one radiation-sensitive additive which effects a change in colour, where the high molecular weight organic material is a natural resin, drying oil, rubber, chlorine rubber, oil-modified alkyd resin, cellulose derivative, polyethylene, polypropylene, polyisobutylene, polystyrene, polyvinyl chloride, polyvinylidene chloride, polyvinyl acetal, polyacrylonitrile, polyacrylate, polymethacrylate or polybutadiene or a copolymer thereof, a polyester, polyimide, polycarbonate, polyurethane, polyether, polyacetal, a condensation product of formaldehyde with a phenol, a so-called phenolic resin, a condensation product of formaldehyde with urea, thiourea or melamine, a so-called amino resin, or one of the polyaddition or polycondensation products of epichlorohydrin with diols or polyphenols which are known as epoxy resins, and where the radiated energy is directed on to the surface of the material to be labelled in accordance with the form of the inscription to be applied and a change in colour occurs at the irradiated areas, wherein the radiated energy which is used is laser light having a wavelength in the UV range between 0.25 and 0.38 $\mu$m and/or in the visible range and/or in the IR range between 0.78 and 2 $\mu$m and the additive which effects a change in colour which is used is at least one inorganic and/or organic pigment and/or a polymer-soluble dye, without the surface of the inscribed material being visibly damaged.

2. A method according to claim 1, wherein a laser with pulsed light is used.

3. A method according to claim 1, wherein a laser beam having a wavelength in the visible and/or close IR range is used.

4. A method according to claim 1, wherein a pulsed or pulse-modified, frequency-doubled Nd:YAG laser or a metal vapour laser is used.

5. A method according to claim 1, wherein the high molecular weight organic material used is polyethylene, polypropylene, polyisobutylene, polystyrene, polyvinyl chloride, polyvinylidene chloride, a polyvinyl acetal, polyacrylonitrile, a polyacrylate or polymethacrylate, polybutadiene, an ABS or EVA copolymer, a polyester, polyamide, polyimide, polycarbonate, polyurethane, polyether, polyacetal, phenolic resin, amino resin or epoxy resin.

6. A method according to claim 1, wherein the high molecular weight organic material used is a linear polyester, polystyrene, polyethylene, polypropylene, ABS, a polyacetal, polyphenylene oxide, polyamide, polycarbonate, polymethyl methacrylate or epoxy resin.

7. A method according to claim 1, wherein the additive used is a metal-containing pigment selected from the series of the inorganic pigments and the metal complexes of azo, azomethine or methine dyes.

8. A method according to claim 1, wherein the additive used is a polymer-soluble dye with an inorganic pigment.

9. A method according to claim 8, wherein titanium dioxide is used as the inorganic pigment.

10. A method according to claim 1, wherein the additive used is an azo, azomethine, methine, anthraquinone, phthalocyanine, perylene, dioxazine, thioindigo, isoindoline, isoindolinone, quinacridone or pyrrolopyrrole pigment.

11. Use of an additive which effects a change in colour for the laser inscription of high molecular weight organic material according to claim 1.

## Revendications

1. Procédé d'inscription visible sur une matière organique macromoléculaire mise en pièces moulées ou pellicules de vernis ou peintures ou encres d'impression, matière contenant un ou plusieurs additifs sensibles aux rayonnements et qui provoquent un changement de couleur, cette matière macromoléculaire étant une résine naturelle, une huile siccative, du caoutchouc ou du caoutchouc chloré, une résine alkyde modifiée avec une huile, un dérivé de la cellulose, du polyéthylène, du polypropylène, du polyisobutylène, du polystyrène, du chlorure de polyvinyle ou de polyvinylidène, un polyvinylacétal, du polyacrylonitrile, un ester polyacrylique ou polyméthacrylique ou du polybutadiène, ou leurs copolymères, un polyester, un polyimide, un polycarbonate, un polyuréthanne, un polyéther, un polyacétal, un produit de condensation du formaldéhyde avec un phénol, un phénoplaste, un produit de condensation du formaldéhyde avec l'urée, la thio-urée ou la mélamine, un aminoplaste ou une résine époxyde, c'est-à-dire un produit de polyaddition ou de polycondensation de l'épichlorhydrine avec des diols ou des polyphénols, et le rayonnement d'énergie correspondant à la forme du signe d'inscription à porter étant dirigé sur la surface de la matière à marquer où les endroits irradiés changent de couleur, procédé caractérisé en ce que l'on utilise comme rayonnement d'énergie une lumière laser dont la longueur d'onde se situe dans l'ultraviolet entre 0,25 et 0,38 μm et/ou dans le visible et/ou dans l'infrarouge entre 0,78 et 2 μm, et comme additif provoquant un changement de couleur un ou plusieurs pigments minéraux et/ou organiques et/ou un ou plusieurs colorants solubles dans les matières polymères, sans que l'on puisse déceler par un examen visuel une altération de la surface inscrite.

2. Procédé selon la revendication 1, caractérisé en ce que l'on opère avec un laser à lumière pulsée.

3. Procédé selon la revendication 1, caractérisé en ce que l'on opère avec un rayon laser dont la longueur d'onde se situe dans le visible et/ou dans le proche infrarouge.

4. Procédé selon la revendication 1, caractérisé en ce que l'on opère avec un laser Nd:YAG pulsé ou à impulsions modifiées et fréquence doublée ou bien avec un laser à vapeur de métal pulsé.

5. Procédé selon la revendication 1, caractérisé en ce que la matière organique macromoléculaire est du polyéthylène, du polypropylène, du polyisobutylène, du polystyrène, du polychlorure de vinyle, du polychlorure de vinylidène, un polyvinylacétal, un polyacrilonitrile, un ester polyacrylique et polyméthacrylique, du polybutadiène, un copolymère ABS ou EVA, un polyester, un polyamide, un polyimide, un polycarbonate, un polyuréthanne, un polyéther un polyacétal, un phénoplaste, un aminoplaste ou une résine époxyde.

6. Procédé selon la revendication 1, caractérisé en ce que la matière organique macromoléculaire est un polyester linéaire, du polystyrène, du polyéthylène, du polypropylène, une résine ABS, un polyacétal, un polyoxyde de phénylène, un polyamide, un polycarbonate, un polyméthacrylate de méthyle ou une résine époxyde.

7. Procédé selon la revendication 1, caractérisé en ce que l'on utilise comme additif un pigment métallifère de la série des pigments minéraux et des complexes de métaux de colorants azoïques, azométhiniques ou méthiniques.

8. Procédé selon la revendication 1, caractérisé en ce que l'on utilise comme additif un colorant soluble dans les matières polymères avec un pigment minéral.

9. Procédé selon la revendication 8, caractérisé en ce que l'on utilise du dioxyde de titane comme pigment minéral.

10. Procédé selon la revendication 1, caractérisé en ce que l'on utilise comme additif un pigment azoïque, azométhinique, méthinique, anthraquinonique, de phtalocyanine, pérylène, dioxazine, thio-indigo, iso-indoline, iso-indolinone, quinacridone ou de pyrrolopyrrole.

11. L'emploi de l'additif provoquant un changement de couleur pour l'inscription au laser sur des matières organiques macromoléculaires conformément à la revendication 1.